# EUROPEAN PATENT APPLICATION

(11) **EP 1 098 367 A2**
(43) Date of publication of application: **09.05.2001**
(21) Application number: 00309336.6
(22) Date of filing: 23.10.2000
(51) Int. Cl.: H01L 23/66

(54) **An electronics package having an integrated filter**

(30) Priority: 05.11.1999 US 434076
(71) Applicant: LUCENT TECHNOLOGIES INC., Murray Hill, New Jersey 07974-0636 (US)
(72) Inventor: Low, Yee Leng, Berkley Heights, New Jersey 07922 (US)
(74) Representative: Buckley, Christopher Simon Thirsk

(57) **Abstract**

An electronics package (100) includes a substrate (105) for providing support for at least one electronic device (110). The substrate incorporates a transmission line based integrated filter (115) having at least one conductive layer formed integrally within or on the substrate and coupled with the electronic device. The dimensions of the conductive trace, configuration of the conductive elements, as well as the shape and dielectric constant of the package's substrate creates a bandpass filter.

## Description

### FIELD OF THE INVENTION

The present invention relates to integrated circuit ("IC") packaging, generally, and more particularly to an electronics package having an integrated filter.

### BACKGROUND OF THE INVENTION

A significant commercial drive exists in reducing the overall size and cost of electronics packaging as ICs have progressively become more complex. Industry, to date, has primarily focused on Ball Grid Array ("BGA") technology for packaging integrated circuits (ICs). BGAs are often, though not exclusively, constructed from plastic or ceramic, and provide a surface mount package for ICs BGAs increase the number of inputs/outputs as a function of a given foot-print, improved electrical/thermal performance, package/board assembly yield, and interconnect density relative to other known packaging technologies. For the purposes of the present disclosure, an electronics package is defined as a package, such as a BGA, comprising an electronics device coupled thereto.

Presently, several types of BGA packages are commercially available, including, for example, Plastic Ball Grid Array ("PBGA") and Ceramic Ball Grid Array ("CBGA"). BGAs typically comprise an area array of solder balls attached to the bottom side of a substrate. Corresponding with the array of solder pads is a number of mounting pads to which the BGA is to be mounted, such as a printed circuit board ("PCB"). The area array of solder balls are heated and then cooled, in a process step also known as reflow, to electrically and mechanically couple the electronics package to the mounting pads of PCB.

Referring to **FIG**. **1**, a known cross-sectional view of a BGA IC package **10** is illustrated. BGA **10** comprises a substrate **12** typically formed from an organic epoxy-glass resin based material, such as, for example, bismaleimide-triazine ("BT") resin or epoxy-glass cloth laminate (FR-4). Substrate **12** structurally comprises a top surface **24** and a bottom surface **26**.

Substrate **12** is intended to provide mechanical support for at least one electronic device **14**. Electronic device **14** may be realized by various electronic components, including for example, an IC(s), discrete device(s), multichip modules, or a combination thereof. Using a bonding process to form a mechanical coupling, device **14** is affixed onto a mounting region of a top surface **24** of substrate **12**. An adhesive resin, such as epoxy, is an advantageous bonding agent, though other known means may also be employed.

Device **14** is electrically coupled with substrate **12** by a number of electrically conductive device terminal pads **20**. Device terminal pads **20** are positioned along a topside **28** of device **14** and are individually connected with a substrate pad **22** via a wire bond **18**. Wire bonds **18** electrically couple device terminal pads **20** and substrate pads **22** together to complete the electrical interface between electronic device **14** to substrate **12**.

With device **14** electrically and mechanically coupled to substrate **12**, the combined structure requires protection from the ambient environment. As such, the structure of substrate **12** having device **14** adjoined thereto is sealed by an encapsulating material **16**. Encapsulating material **16** may comprise any one several insulating materials including, for example, a ceramic or plastic resin.

To enable the encapsulated structure to interface with other external electrical elements, an array of solder balls **30** are formed on bottom side **26** of substrate **12**. Array **30** typically takes the shape of a grid pattern. Each solder ball **30** of the array is adjoined to a bottom surface pad **32**. Bottom surface pads **32** are electrically coupled to substrate pads **22** through conductive vias (not shown) to provide a complete external electrical interface to the device **14** through package **10**. Subsequently, solder balls **30** are reflowed to mechanically and electrically couple the encapsulated package **10** with a PCB.

Various problems, however, exist with electronics packaging generally, and more specifically BGAs. Electronic devices are being driven to operate at higher frequencies all while their geometries are being shrunk. With the density and functionality of electronic devices growing, there has been an increase in the number and concentration of package pins required for electronic devices to communicate with other devices on a PCB. At higher switching frequencies, capacitive loading and coupling parasitics significantly degrade the speed and quality of signals of an electronic device within a package. Moreover, parasitic effects generated from various electrical paths connecting the electronic device to the increased number of package pins also multiplies, which may result in spurious noise and logic errors. For the purposes of the present disclosure the term parasitic means a generally undesirable inherent element in an electrical circuit as manifested in the form of, for example, wire resistance, conductor capacitance, or connector inductance.

These aforementioned parasitic effects are especially pronounced for those signals that are initiated externally from a PCB, through an electronics package, and into, for example, an IC. This path includes a package pin of a PCB component, a PCB signal trace, an IC package pin, one or more vias, a signal trace or power plane, the package bond pad, the wire bond, and the integrated circuit terminal pad. These issues are generally discussed in U.S. Patent Number 5,917,233, hereby incorporated by reference. Each of these elements contributes a parasitic inductance, capacitance, and resistance to the signal path. This parasitic impedance may seriously distort the quality of signals processed by the IC. As a result, the operation of the entire IC may be compromised. This inherent shortcoming is known to be even more acute at higher frequencies, such as, for example, 1 GHz and above. In view of the need for interconnects which are large enough to carry sufficient current, long enough for simplified fabrication, yet possessing a negligible inductance to enable effective high frequency operation, it has proven increasingly difficult to electrically couple an IC to a PCB using known BGA packages without incurring an undesirable amount of parasitic effects.

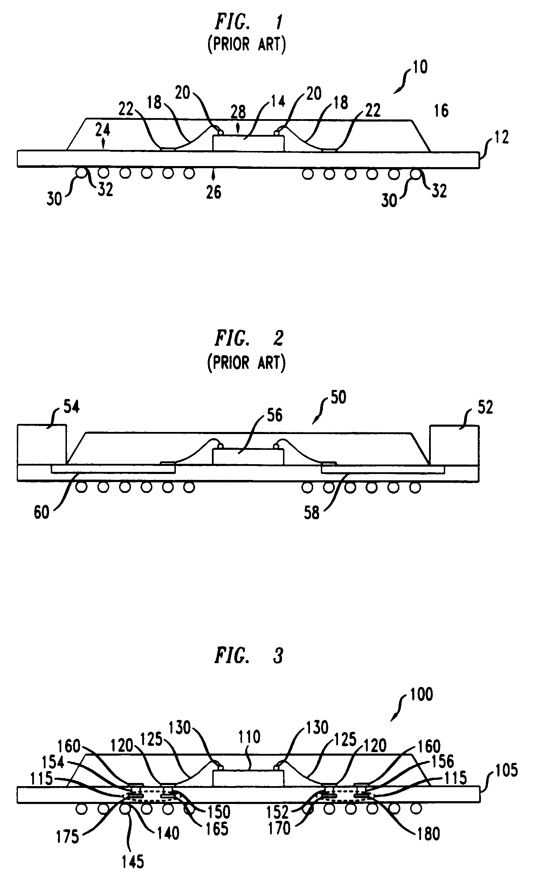

In view of the above, the addition of discrete component to the package raises additional issues regarding parasitic effects. Referring to **FIG. 2**, a known BGA IC package 5**0** is illustrated. Package assembly **50** comprises a similar structure as shown in **FIG. 1** with the addition of a discrete filters, **52** and **54**. Discrete filters **52** and **54** are intended to remove unwanted frequencies from electronics device **56** within package **50**. Various realizations are available for discrete filters, including a capacitor or inductor, individually, or a combination thereof, arranged in series or parallel with or without a discrete resistor.

Several shortcomings however exist in incorporating within the package discrete components, generally, and filters, more specifically, for removing unwanted frequencies from the electronics packages. These failings include complexity and cost associated with the discrete components, as well as the effective use of space. While enhancing the performance of the electronics within the package assembly, discrete filter components are costly on a volume scale, production basis.

Moreover, the inclusion of discrete filter components requires an excessive amount of packaging real estate. The size of the discrete components in these parasitic filters is proportionate to the operating frequency of the resultant ICs within the electronics package. In a "package" designed to operate in the GHz range and above, for example, these discrete components require a length on the order of a couple of inches. This additional space requirement might otherwise go to offering greater package functionality or reducing the package size. Moreover, given their size, the spacing between the electronics device and the discrete filter components to fit within the package requires additional complexity. To adequate couple both device and the filter components, a pair of leads **58** and **60** must be formed, the length of which proportionally creates additional parasitic effects. Thus, a tradeoff analysis must be performed when considering the use of discrete filtering schemes.

As an alternative to these large discrete filter components, the incorporation of such a filter as part of a semiconductor-based solution has also been examined. A semiconductor-based filter is formulated within semiconductor substrate as part of the semiconductor device during the processing steps in fabricating an IC, and thus requires additional semiconductor die space. While such a solution is seamless and dimensionless to the naked eye, the cost of realizing a filter from on a semiconductor substrate is an inefficient use of die space. In actuality, semiconductor die space may be substantially greater in cost than that of an electronics package utilizing discrete filter components. Moreover, a semiconductor-based filter may also be impractical because its conductive nature may shift the frequency response desired.

In view of the above, a demand exists for a filter for removing unwanted frequencies effects in an electronic packaging assembly having a low incremental cost in volume production. Further, there is a need for an electronic packaging assembly having an integrated filter that more efficiently uses space.

### SUMMARY OF THE INVENTION

One advantage of the present invention is to provide an electronics packaging assembly having a low incremental cost in volume production.

A further advantage of the present invention is to provide an electronics packaging assembly having an integrated filter for efficiently using space.

To achieve the advantages of the present invention, an electronics package is disclosed herein having a filter integrated within the package itself for removing unwanted frequencies. The integrated filter is advantageously realized by employing a series of conductive traces integrated within the package's dielectric substrate. The series of conductive traces form a transmission line based parasitic filter with a frequency response dependent and proportional to the dimensions and configuration of the conductive elements, as well as the shape and dielectric constant of the package's substrate. These characteristics are thereby selected to formulate a filter design accordingly.

In one embodiment of the present invention, the series of conductive traces are positioned below the device interconnects. The interconnects couple the electronic device to the substrate. By locating the conductive traces in close proximity with the relevant interconnects, the distance between these elements, and thereby reduce parasitic effects are minimized.

Optimally, the present invention provides substantial performance advantages, particularly at higher frequencies. These include lower production costs given the simplified manufacturing required, as well as superior package performance.

These and other advantages will become apparent to those skilled in the art from the following detailed description read in conjunction with the appended claims and the drawings attached hereto.

### BRIEF DESCRIPTION OF THE DRAWINGS

The present invention will be better understood from reading the following description of non-limiting embodiments, with reference to the attached drawings, wherein below:
**FIG. 1** illustrates a cross-sectional view of a first known ball grid array package;
**FIG. 2** illustrates a cross-sectional view of the a known ball grid array package modified to reduce the effects of parasitics;
**FIG. 3** illustrates a cross-sectional view of a first embodiment of the present invention;
**FIG. 4** illustrates a top view of the first embodiment of the present invention;
**FIG. 5** illustrates the frequency characteristics of the first embodiment of the present invention; and
**FIG. 6** illustrates a cross-sectional view of a second embodiment of the present invention.

It should be emphasized that the drawings of the instant application are not to scale but are merely representations and thus are not intended to portray the specific parameters or the structural details of the invention, which may be determined by one of skill in the art by examination of the information contained herein.

### DETAILED DESCRIPTION OF THE PRESENT INVENTION

Referring to **FIG. 3**, a cross-sectional view of a first embodiment of an electronics package **100** according to the present invention is illustrated. Electronics package **100** comprises a substrate **105** for providing mechanical support for at least one electronic device **110**. It is advantageous for substrate **105** to comprise epoxy-glass cloth laminate (FR-4). However, it should be noted that other materials apparent to one of ordinary skill in the art, such as an organic epoxy-glass resin based material, including, for example, bismaleimide-triazine ("BT") resin, may be used alternatively.

Substrate **105** comprises a mounting region where at least one electronic device **110** is mechanically coupled thereto, such that an electrical coupling between substrate **105** and device **110** is maintained. Electronic device **110** may be realized by various electronic components including, for example, an IC(s), discrete device(s), multichip modules, or a combination thereof. Using a bonding process, device **110** is affixed onto a mounting region of substrate **105** by an adhesive resin, such as epoxy, though various other means may be employed.

In a first embodiment of the present invention, device **110** is electrically coupled with substrate **105** through electrically conductive device terminal pads **130**. Device pads **130** are positioned along the top of device **110** such that each device pad **130** is coupled with a substrate pad(s) **120** using a wire bond **125**. While wire bonds **125** complete the electrical interface of substrate **105** with device **110**, this coupling arrangement causes undesirable parasitic effects. Each wire bond, in effect, acts as a loop or whip antenna from which parasitic electromagnetic energy is radiated.

To minimize the introduction of additional parasitic effects, a filter integrated within the package is incorporated for removing unwanted frequencies. The integrated filter comprises at least one conductive trace or element **115** configured within substrate **105** to form a transmission line based integrated filter. It is advantageous, however, to realize the integrated filter by employing a series of conductive traces or elements. In such a beneficial design, a first conductive layer **165** of the series is coupled with a device pad **120** through a first device pad connector **150**. Moreover, a second conductive layer **170** of the series is coupled with a device pad **120** through a second device pad connector **152**. A third and fourth conductive layers, **175** and **180**, of the series, are likewise coupled with respective pads **160** by pad connectors, **154** and **156**. It should be noted that for the purposes of the present invention, the term integrated shall mean formed during the fabrication of the substrate as detailed hereinbelow, and typically, formed within a dielectric base of the substrate.

By the above arrangement, a transmission line based integrated filter is formed from the series of conductive elements **115**. The transmission line based integrated filter may advantageously be realized by a stripline structure. Other configurations, however, such as a microstrip design, will become apparent to one or ordinary skill in the art upon reviewing the present invention. By themselves, transmission line filters are known and detailed in depth in Pozar, Microwave Engineering, Addison-Wesley Publishing Co., 1990, pp. 177-190 (hereinafter "Pozar"), and Rhea, HF Filter Design and Computer Simulation, McGraw-Hill, Inc., 1995, pp. 105-116 (hereinafter "Rhea"), both of which are hereby incorporated by reference.

Transmission line filters have a frequency response dependent and directly proportional to the dimensions and configuration of the conductive elements **115**, as well as the shape and dielectric constant of substrate **105**. The operation, functionality, layout and design requirements of transmission line filters by themselves are known in the art, and discussed in U.S. Patent Numbers 4,233,579 and 5,024,966 both commonly assigned with the present invention, U.S. Patent Numbers 4,266,206, 4,701,727 and 5,160,905, as well as Rhea, pp. 86-90, 105-116, 285-395, and 413-420, and Pozar, pp. 336-343 and 506-526, all of which are hereby incorporated by reference.

The series of conductive elements **115** may be fabricated as an integrated filter within substrate **105** using any one of various known methods upon review of the instant disclosure. In an advantageous method, substrate **105** is formed from a first and second material substrate each having a conductive layer disposed on both sides. It is beneficial that both first and second material substrates comprise FR-4 having an epoxy-glass cloth dielectric core and conductive copper layers on both sides. A patterning step is performed on one conductive side of the first material substrate. This step may utilize any one of the techniques known or apparent to one of ordinary skill in the art. As a result of patterning one conductive side of the first material substrate, the layout of the series of conductive elements **115** is formed. A portion of the first conductive side of the second substrate is also removed to create a pattern for the dielectric base underlying the conductive side. Using this approach, the ability to mate patterned conductive side of the first material substrate with the patterned dielectric base of the second substrate is enhanced. It is advantageous, nonetheless, to remove the first conductive side of the second substrate and expose the dielectric base without a forming a corresponding pattern to simplify manufacturing. Subsequently, the series of conductive elements **115** of the first material substrate are aligned with the exposed dielectric base of the second material substrate and then laminated using various techniques apparent to one of ordinary skill in the art, including applying an adhesive resin, such as epoxy. As a result of this lamination process step, the series of conductive elements **115** are embedded in the resultant substrate structure **105** to form the integrated filter having minimal parasitic effects.

It is advantageous for the controlled impedance of the series of conductive elements forming the transmission line based integrated filter to be approximately 50 Ω. This value is targeted to provide package **100** with an output impedance matching external circuits or devices on a PCB. It should be noted that the controlled impedance of the transmission line integrated filter directly corresponds with the materials employed as well as the dimensions of the conductive strips created by patterning each conductive side.

Moreover, the loss tangent of the transmission line based integrated filter in the substrate is approximately less than or equal to 0.02. Loss tangent is defined as energy stored divided by the energy dissipated. Much like its controlled impedance, the loss tangent of the transmission line based integrated filter is intended to improve the performance of package **100**.

It is advantageous to protect the package **100** from its ambient environment given the electrically and mechanically coupling of substrate **105** with device **110**. As such, substrate **105** with device **110** adjoined thereto is sealed by an encapsulating material **135**. As detailed hereinabove, encapsulating material **135** may comprise various protective materials. In one embodiment, encapsulating material **135** comprises a silicon dielectric gel RTV6186 made available by GE Silicones, which upon curing, has a dielectric constant of 2.8 at 1KHz, and a volume resistivity of 1 x 10¹⁵ Ω-cm. It should be apparent to one of ordinary skill that substitutes may be employed to encapsulate device **110**.

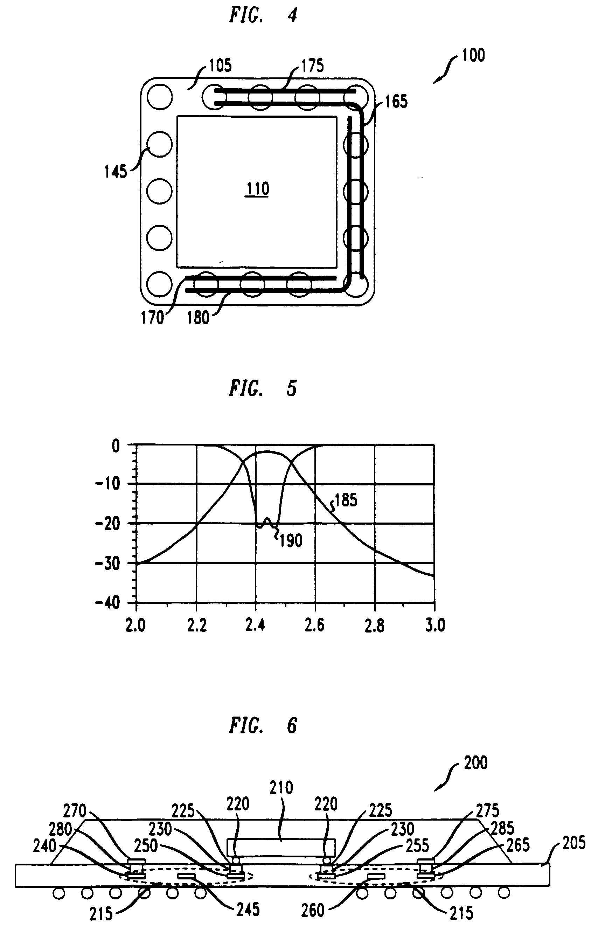

Referring to **FIG. 4,** a top view of package **100** of **FIG. 3** of the present invention is illustrated. Here, an advantageous layout of the conductive layers **165**, **170**, **175** and **180** is depicted. As detailed hereinabove, conductive layers **165**, **170**, **175** and **180** form a transmission line based integrated filter. Other arrangements and designs, such as a different number conductive layers within and without the same plane, a stacked arrangement, as well as a filter design which encompasses the entire periphery or different portions thereof, will be apparent to one of ordinary skill upon understanding the present invention.

In one embodiment of the present invention detailed hereinabove, conductive layers **165** and **170** are coupled with the device, while conductive layers **175** and **180** are separated from conductive layers **165** and **170** by a dielectric material, such as air, epoxy, encapsulant or laminate, for example. From a functional standpoint, a capacitance is also created between each of the conductive layers **165**, **170**, **175**, and **180**. This is principally based on the ability of layers **165**, **170**, **175**, and **180** to store charge and the insulated spacing therebetween to form a capacitance. By this arrangement, a filter is formed to reduce the effects of the parasitic impedance created by adjoining the wire bonds **125** to both substrate **105** and device **110**. The integrated filter of the present invention, thus, is realized by the series of conductive elements **115** within substrate **105** of electronics package **100**.

In one embodiment of the present invention, conductive layers **165**, **170**, **175** and **180** forming the transmission line based integrated filter comprises a height substantially in the range of 1-2mm, and a width substantially in the range of 1-2mm. The length of each of conductive layers **165**, **170**, **175** and **180** may be viewed in this embodiment as a series of segments. Here, conductive layers **165** and **170** each comprise one segment having a length substantially corresponding to one quarter (1/4) the wavelength of the resonant frequency of the desired filter. As such, the each segment has a length substantially in the range of 10-25mm. Conductive layers **175** and **180**, give their configuration, comprise two segments each of which having a length substantially in the range of 10-25mm.

In another embodiment of the present invention, each segment of at least one conductive **170**, **175** and **180** are advantageously gap coupled together, though edge coupling may also be employed. In yet another embodiment, at least one conductive layers **170**, **175** and **180** are gap coupled with at least one probe pad (not shown). Alternatively, at least one of conductive layers **170**, **175** and **180** is edge coupled with at least one probe pad, which in turn is coupled with a solder ball of the array of solder balls **145**.

Referring to **FIG. 5**, a graph of the frequency characteristics of the transmission line based filter of an embodiment of **FIG. 4** is illustrated. From the graph, a first curve **185** shows the conductive elements **115** as a bandpass filter allowing energy to pass through within a predetermined band of frequencies. Moreover, the graph additionally illustrates the intended functional purpose of the transmission line based integrated filter as substantially minimizing the import of energy outside the defined band of frequencies.

As depicted in the graph of **FIG. 4**, a frequency band for the transmission line based integrated bandpass filter is selected at approximately (-)20dB. The bandpass range is as a result if approximately 2.2 GHz to 2.7 GHz. Moreover, a second curve **190** demonstrates, in the frequency domain, energy reflected back within the transmission line. It should be apparent to one of ordinary skill that this reflected energy should be reduced to increase the efficiency of the transmission line based integrated bandpass filter. To improve the performance of the filter, the selected frequency band is arrived at by considering the performance characteristics of first curve **185** in view of the reflected energy in second curve **190**.

Referring to **FIG. 6**, an alternate approach to the present invention is illustrated. Here, a cross-sectional view of an electronics package **200** utilizing flip-chip technology is presented. Flip chip bonding is known and detailed in U.S. Patent Numbers 5,834,160, 5,858,814, and 5,898,223, commonly assigned with the present invention, as well as U.S. Patent Number 5,444,296, 5,514,334, and 5,773,889, all of which are hereby incorporated by reference.

Flip-chip bonding involves "flipping" the active surface side of the electronic device, such as, for example, a bare semiconductor die. This flipping step results in aligning the conductive solder bump pads on the bare semiconductor die side with a receptive region, such as a heat slug or a series of corresponding solder bump pads, of the substrate. Subsequently, the semiconductor die and substrate are bonded by a reflow step to form a mechanical and electrical coupling. A reflow step comprises sufficiently heating the semiconductor die's solder bumps pads to cause each to melt with their respective counterparts on the substrate and then cool to form a mechanical joint and an electrical contact for each bump pad. By employing this flip-chip bonding technique, higher density interconnections may be realized for ICs having lower parasitic effects than with the more traditional wire bond technologies. It should be noted, however, that in an alternative embodiment, the active surface side of the electronic device is not flipped, but is, rather, oriented such that conductive solder bump pads on the bare semiconductor die side may be aligned with a receptive region and then bonded by a reflow step.

Electronics package **200** comprises a substrate **205** for providing mechanical support for at least one electronic device **210**. Electronic device **210** may be realized by various electronic components including, for example, an IC(s), semiconductor die/dice, discrete device(s), multichip modules, or a combination thereof. Substrate **205** is realized advantageously by an epoxy-glass cloth laminate (FR-4). However, it should be noted however that other materials apparent to one of ordinary skill in the art, such as an organic epoxy-glass resin based material, for example, bismaleimide-triazine ("BT") resin, may be used alternatively.

Using the flip chip bonding process detailed hereinabove, device **210** is mechanically and electrically coupled with substrate **205**. Device **210** is coupled with substrate **205** through a number of electrically conductive device terminal pads **220**. Device pads **220** are positioned along device **210** such that each device pad **220** is coupled with a select substrate pad **225**. To complete the interconnection between substrate **205** to device **210**, a solder bump is incorporated on each device terminal pad **220** of device **210**. Each solder bump is aligned with a corresponding solder-wettable metallization end of a substrate pad **225**. Subsequently, a solder reflow forms all of the solder bonds to electrically couple substrate **205** with device **210**.

By coupling substrate **205** to device **210** using flip chip bonding, the need for wire bonds is eliminated. In so doing, the parasitic impedance created by the substrate-device interface is reduced over other bonding arrangements detailed hereinabove. This reduction in parasitic impedance is attributable to the closer in proximity, more direct interconnections between substrate **205** and device **210** and as such the elimination of wire bonds.

Moreover, electronics package **200** further comprises at least one conductive trace or element **215**. Conductive trace **215** is configured within substrate **205** to form a transmission line based integrated filter. It is advantageous, however, to realize the transmission line based integrated filter by employing a series of conductive traces or elements. In such a beneficial design, a first conductive layer **250** is coupled with a first device pad **225** through a first device pad connector **230**. Moreover, a second conductive layer **255** is coupled with a second device pad **225** by means of a second device pad connector **225**. An input of the transmission line based integrated filter is thereby coupled with the device-substrate structure. Third and fourth conductive layers, **240** and **265**, are coupled with respective pads, **270** and **275**, via first and second ground pad connectors **280** and **285**. Moreover, fifth and sixth conductive layers, **245** and **260**, further embellish the performance of the transmission line based integrated filter and are positioned between first and third conductive layers, **250** and **240**, and second and fourth conductive layers, **255** and **265**, respectively.

By the above arrangement in the instant embodiment, a transmission line based integrated filter is formed from the series of conductive elements **215**. The integrated filter created is realized advantageously by a stripline structure. However, the parasitic filter may also comprise a microstrip design, as well as other configurations apparent to one or ordinary skill in the art upon reviewing the present invention. As noted above, the frequency response of a transmission line based integrated filter is dependent on and directly proportional to the dimensions and configuration of the conductive elements **215**, as well as the shape and dielectric constant of substrate **205**.

The controlled impedance of the series of conductive elements **215** forming the transmission line based integrated filter is advantageously set at approximately 50 Ω. This value is targeted to provide package **200** with an output impedance matching any external circuits or devices on a PCB. It should be noted that the controlled impedance of the integrated filter, as noted hereinabove, directly corresponds with the materials employed as well as the dimensions of the conductive strips created by the patterning of each conductive side.

Moreover, the loss tangent of the transmission line based integrated filter in the substrate is approximately less than or equal to 0.02. Loss tangent is defined as energy stored divided by the energy dissipated. Much like its controlled impedance, the loss tangent of the integrated filter is intended to improve the performance of package **200** with respect to external circuits on the PCB.

With device **210** coupled with substrate **205**, package **200** is protected from ambient atmosphere by an encapsulating material **235**. Substrate **205** with device **210** adjoined thereto is sealed by material **235**. As detailed hereinabove, encapsulating material **235** may comprise various protective materials. In one embodiment, encapsulating material **235** comprises a silicon dielectric gel RTV6186 made available by GE Silicones, which upon curing, has a dielectric constant of 2.8 at 1KHz, and a volume resistivity of 1 x 10¹⁵ Ω-cm. It should be apparent to one of ordinary skill that substitutes may be employed to encapsulate device **210**. In one embodiment of the present invention, conductive elements **215** forming the transmission line based integrated filter each comprise a height substantially in the range of 1-2mm, and comprise a width substantially in the range of 1-2mm. Each conductive element may comprise any number of segments, depending on the configuration of the transmission line, the length of each segment corresponding to one quarter (1/4) the wavelength of the resonant frequency of the desired filter. As such, the each segment in this embodiment has a length substantially in the range of 10-25mm.

In another embodiment of the present invention, each segment of a particular conductive element **215** is advantageously gap coupled together, though edge coupling may also be employed. In yet another embodiment, at least one conductive element **215** is gap coupled with at least one probe pad (not shown). Alternatively, at least one of conductive layers **170**, **175** and **180** is edge coupled with at least one probe pad. The probe pad is coupled with a solder ball of the array of solder balls **145**.

Several variations to the hereinabove detailed embodiments to the present invention should be noted. First, while the conductive element(s) forming the aforementioned transmission line based filter may be integrated within the electronic package's substrate. In the alternative, the conductive element(s) may also be formed on the top side or bottom side of the substrate, as well as a combination of integrated, top, and/or bottom side. Moreover, each conductive trace forming the transmission line may be positioned on a different plane and/or orientation that the other conductive traces of the series. Similarly, while a BGA is detailed hereinabove, the invention may be in various other electronics package known to one of ordinary skill including a Plastic Ball Grid Array ("PBGA"), a Ceramic Ball Grid Array ("CBGA"), a Thin Ball Grid Array ("TBGA"), an Ultra Thin Ball Grid Array ("UTBGA") and a Quality Flat Package ("QFP") design.

The hereinabove embodiments of the present invention provide substantial performance advantages, particularly at higher frequencies, over the solutions posed in the known art. These include lower production costs given the simplified manufacturing required, as well as superior package performance. These enhancements are attributable in part due to the negligible area required to create conductive elements within package substrate.

While the particular invention has been described with reference to illustrative embodiments, this description is not meant to be construed in a limiting sense. It is understood that although the present invention has been described in the embodiments, various modifications of the illustrative embodiments, as well as additional embodiments of the invention, will be apparent to persons skilled in the art upon reference to this description without departing from the spirit of the invention, as recited in the claims appended hereto. Therefore, while the present disclosure details a parasitic filter integrated within an electronic package, it should be apparent to one of ordinary skill of its broader applications such as where two or more substrates are coupled together, as well as various other techniques where an electronics device is coupled with a substrate. It is therefore contemplated that the appended claims will cover any such modifications or embodiments as fall within the true scope of the invention.

## Claims

1. An electronics package comprising:
at least one electronic device;
a substrate for mechanically and electrically coupling with the at least one electronic device; and
a transmission line based filter integrated with the substrate and coupled with the at least one electronic device.

2. The electronics package of claim 1, wherein the transmission line based filter comprises at least one conductive layer having dimensions and a configuration to form a bandpass filter.

3. The electronics package of claim 2, wherein the at least one conductive layer comprises conductive traces integrated within the substrate.

4. The electronics package of claim 2, wherein the at least one conductive layer wraps around a portion of the substrate.

5. The electronics package of claim 2, wherein the at least one conductive layer comprises at least one of stripline structure and a microstrip structure.

6. The electronics package of claim 1, wherein the at least electronic device is coupled with the substrate by at least one of wire bonding and flip chip bonding.

7. The electronics package of claim 1, wherein the at least one electronic device comprises at least one of an integrated circuit, a multichip module, and a discrete component.

8. The electronics package of claim 1, wherein the electronics package comprises at least one of a BGA, PBGA, CBGA, TBGA, UTBGA, and QFP design.

9. The electronics package of claim 1, wherein the transmission line based parasitic filter comprises a controlled impedance of 50 ohms, and loss tangent of less than or equal to 0.02.

10. An electronics package having at least one electronic device, the electronics package comprising:
a substrate for mechanically and electrically coupling with the at least one electronic device; and
a transmission line based filter integrated with the substrate and coupled with the at least one electronic device, the transmission line based integrated filter comprising at least one conductive layer forming a bandpass filter.

11. The electronics package of claim 2 or 10, wherein the at least one conductive layer is formed on a dielectric base of the substrate.

12. The electronics package of claim 2 or 10, wherein the at least one conductive layer is formed within a dielectric base of the substrate.
